# EUROPEAN PATENT APPLICATION

(11) **EP 3 598 519 A1**
(43) Date of publication of application: **22.01.2020**
(21) Application number: 18846626.2
(22) Date of filing: 28.04.2018
(51) Int. Cl.: H01L 51/52

(54) **ORGANIC ELECTROLUMINESCENT APPARATUS AND ELECTRODE THEREFOR**

(30) Priority: 16.08.2017 CN 201721024404 U
(71) Applicant: Kunshan Go-Visionox Opto-Electronics Co., Ltd., KunShan City, Jiangsu 215300 (CN)
(72) Inventor: MIN, Chao, Kunshan Jiangsu 215300 (CN); TIAN, Jingwen, Kunshan Jiangsu 215300 (CN); LIU, Shengfang, Kunshan Jiangsu 215300 (CN)
(74) Representative: D'Halleweyn, Nele Veerle Trees Gertrudis
(86) International application number: PCT/CN2018/085171
(87) International publication number: WO 2019/033794

(57) **Abstract**

The present disclosure discloses an organic light-emitting device and an electrode thereof. The electrode includes a first conductive layer, and further includes a second conductive layer laminated at a first side of the first conductive layer. The second conductive layer is a transparent conductive layer. The electrode includes the first conductive layer and the second conductive layer laminated at the first side of the first conductive layer, that is, in the present disclosure, by using the transparent conductive layer laminated at the first side of the first conductive layer, light is reflected multiple times inside the electrode, enabling to generate a microcavity effect and a destructive interference effect, thereby enabling to improve an extraction efficiency of the light.

## Description

### TECHNICAL FIELD

The present disclosure relates to the field of display technologies, and particularly relates to an organic light-emitting device and an electrode thereof.

### BACKGROUND

Compared with the liquid crystal display device, the organic light-emitting device (OLED) having advantages such as self-illumination, quick response, wide viewing angle, high brightness, brilliant color, light and thin, and the like, is considered to be the display technology for the next generation. A self-illuminated element thereof, that is, an organic light-emitting diode, is mainly composed of a positive electrode layer, an organic material functional layer (generally including functional layers such as an electron transport layer, an organic functional layer, a hole transport layer and the like) and a negative electrode layer which are provided away from a substrate in sequence. Depending on different directions of light emission, the OLED may be classified into two types: a bottom light-emitting type (i.e., emitting light downward with respect to a substrate) and a top light-emitting type (i.e., emitting light upward with respect to a substrate).

Since the negative layer is generally composed of a metal simple substance and/or an alloy material which have a low work function, a light transmittance thereof is low. In order to reduce an influence of the negative layer on an overall light extraction efficiency of the top light-emitting type OLED, a thickness of the negative layer is generally at the nanoscale, and at the same time, a reflective metal is adopted as the positive layer to further increase the light transmittance. However, the smaller the thickness of the negative layer is, the larger the resistance Rs of a square resistance thereof is, resulting in a severe voltage drop of the top light-emitting organic light-emitting diode. In addition, since the top light-emitting OLED adopts the negative layer as light-emitting side, and the material composing the negative layer has a low light transmittance, the negative layer corresponds to a layer of a semitransparent film having a reflective function, so that a microcavity is formed between the negative layer and the reflective positive layer below the negative layer, resulting in a strong microcavity effect in the top light-emitting OLED. Therefore, the above factors all lead to difficulties in mass production of the top light-emitting OLED at present.

Thus, at present, the OLED mostly adopts a bottom light-emitting structure with a simple preparation process and a relatively mature technology. The light emitted from the bottom light-emitting OLED passes through the positive layer and is emitted from a side of the substrate. The positive layer is generally made of Indium Tin Oxide (ITO) material having a high work function and a high light transmittance.

However, the light transmittance of an ITO film is high, and it is hard to form a microcavity effect which is advantageous for light extraction. Moreover, since the ITO film is easy to form a coupling extinction system with a package substrate, a light extraction efficiency of the OLED is affected.

### SUMMARY

Thus, the present disclosure is to solve the problem of the low light extraction efficiency of the organic light-emitting device in the prior art, thereby providing an electrode applicable to an organic light-emitting device and an organic light-emitting device including the electrode.

According to an aspect of the present disclosure, an electrode applicable for an organic light-emitting device is provided. The electrode has a first side and a second side opposite to the first side, and further includes: a first conductive layer; and a second conductive layer laminated at the first side of the first conductive layer, the second conductive layer being a transparent conductive layer.

Alternatively, the electrode further includes a third conductive layer laminated at the second side of the first conductive layer. The third conductive layer is a transparent conductive layer.

Alternatively, the first conductive layer is a transflective conductive layer.

Alternatively, the third conductive layer has a thickness ranging from 50 nm to 80 nm.

Alternatively, the second conductive layer has a thickness ranging from 20 nm to 50 nm.

According to another aspect of the present disclosure, an organic light-emitting device is provided. The organic light-emitting device includes a first electrode, an organic functional layer and a second electrode sequentially laminated on a substrate. The first electrode has a first side and a second side opposite to the first side, and further includes: a first conductive layer; and a second conductive layer laminated at the first side of the first conductive layer, the second conductive layer being a transparent conductive layer.

Alternatively, the first conductive layer is a transflective conductive layer.

The electrode further includes a third conductive layer laminated at the second side of the first conductive layer. The third conductive layer is a transparent conductive layer.

Alternatively, the third conductive layer has a thickness ranging from 50 nm to 80 nm.

Alternatively, the second conductive layer has a thickness ranging from 20 nm to 50 nm.

Alternatively, the second electrode is a reflective electrode.

Alternatively, a microcavity structure is formed by the second electrode and the first electrode.

Alternatively, an organic light-emitting device includes a first electrode, an organic functional layer and a second electrode sequentially laminated on a substrate, wherein the first electrode has a first side and a second side opposite to the first side, and includes:
a first conductive layer;
a second conductive layer, laminated at the first side of the first conductive layer, wherein the second conductive layer is a transparent conductive layer.

Alternatively, the electrode further includes a third conductive layer laminated at the second side of the first conductive layer.

The third conductive layer is a transparent conductive layer.

Alternatively, a microcavity structure is formed by the second electrode and the first electrode.

Alternatively, a microcavity structure is formed by the second electrode and the first conductive layer of the first electrode, when the second electrode is a reflective electrode.

Alternatively, the organic light-emitting device further includes a substrate. The substrate and the first conductive layer are provided on opposite sides of the second conductive layer. The second conductive layer is provided at a position close to the second electrode, and the third conductive layer is provided at a position close to the substrate.

The technical solution of the present disclosure has the following advantages.
1. The electrode provided in the present disclosure includes the first conductive layer, and further includes the second conductive layer laminated at the first side of the first conductive layer. The second conductive layer is a transparent conductive layer. The electrode includes the first conductive layer and the second conductive layer laminated at the first side of the first conductive layer, that is, in the present disclosure, by using the transparent conductive layer laminated at the first side of the first conductive layer, light is reflected multiple times inside the electrode, enabling to generate a microcavity effect and a destructive interference effect, thereby enabling to improve an extraction efficiency of the light.
2. In the electrode provided in the present disclosure, the first conductive layer is a transflective conductive layer. The transflective conductive layer has a transflective property, and enable to form a microcavity structure with the reflective electrode, thereby improving the extraction efficiency of the light with coupling enhancement of the light.
3. In the electrode provided in the present disclosure, the third conductive layer has a thickness ranging from 50nm to 80nm. The thickness of the third conductive layer is equal to one quarter of a wavelength of the light in the third conductive layer. When the light is again emitted from air toward the electrode, since reflected light from both surface of the third conductive layer both have half-wave loss, an optical path difference between the reflected light from the rear surface of the third conductive layer and the reflected light from the front surface of the third conductive layer is exactly a half wavelength. At this time, it is not the reflected light and the incident light but the reflected light from the front and rear surfaces of the third conductive layer that has the destructive interference effect, thereby increasing the energy of the transmitted light and improving the extraction efficiency of the light.
4. The organic light-emitting device provided in the present disclosure includes the first electrode, the organic functional layer and the second electrode. The first electrode includes the first conductive layer, and further includes the second conductive layer laminated at the first side of the first conductive layer. The second conductive layer is a transparent conductive layer. In the present disclosure, by using the laminated first electrode including the first conductive layer and the transparent conductive layer laminated at the first side of the first conductive layer, light is reflected multiple times inside the electrode, enabling to generate the microcavity effect and the destructive interference effect, thereby enabling to improve the extraction efficiency of the light.
5. In the organic light-emitting device provided in the present disclosure, the second electrode is a reflective electrode. A microcavity structure is formed by the reflective electrode and the first conductive layer having a transflective property, thereby facilitating the coupling enhancement of the light.

### BRIEF DESCRIPTION OF THE DRAWINGS

To describe the technical solutions of the embodiments of the present disclosure or the prior art more clearly, the following briefly introduces the accompanying drawings required for describing the embodiments or the prior art. Apparently, the accompanying drawings in the following description show some embodiments of the present disclosure, and a person skilled in the art may also derive other drawings from these accompanying drawings without creative efforts.
FIG. 1 is a schematic structural diagram of an electrode according to a first embodiment of the present disclosure.
FIG.2 is a schematic structural diagram of an electrode according to a second embodiment of the present disclosure.
FIG.3 is a schematic structural diagram of an electrode according to a third embodiment of the present disclosure.
FIG. 4 is a schematic structural diagram of an organic light-emitting device according to a fourth embodiment of the present disclosure.

### DETAILED DESCRIPTION OF THE EMBODIMENTS

To illustrate objects, technical solutions and advantages of the present disclosure more clearly, embodiments of the present disclosure will be described in detail below with reference to the accompanying drawings.

In the description of the present disclosure, it should be noted that, although the terms "first" and "second" may be used herein to describe various features/elements, these features/features are not limited by these terms, unless specifically indicated otherwise. These terms may be used to distinguish one feature/element from another feature/element. Thus, a first feature/element described below may be referred to as a second feature/element. Similarly, a second feature/element discussed below may be referred to as a first feature/element without departing from the scope of the present disclosure.

The present disclosure may be implemented in many different forms and should not be construed as being limited to the embodiments set forth herein. In contrast, these embodiments are provided so that the present disclosure will be thorough and complete, and the concept of the present disclosure will be fully conveyed to those skilled in the art. The present disclosure will only be defined by the claims. In the accompanying drawings, dimensions and relative dimensions of layers and regions may be exaggerated for clarity. It should be understood that when an element such as a layer, a region, or a substrate is referred to as "formed" or "provided" "on" another element, the element may be directly provided on the another element, or there may be an intermediate element. In contrast, when an element is referred to as "directly formed" or "directly provided" on another element, there is no intermediate element.

In an embodiment of the present disclosure, the first conductive layer 11 may be any one of gold, silver, aluminum, molybdenum, copper, titanium, chromium, indium, and tin, or an alloy composition or a metal oxide of at least two of them. The first conductive layer 11 has a transmittance ranging from 5% to 95%, and a thickness ranging from 200 nm to 700 nm. For example, the thickness may be 200 nm, 300 nm, 550 nm, 600 nm, 700 nm, and the like. In this case, the first conductive layer is formed as a transflective conductive layer.

The second conductive layer 12 is made of transparent alkali metal oxide having a high work function, to reduce an injection barrier of holes and improve an injection efficiency of the holes. For example, the second conductive layer 12 may be made of Al₂O₃, Fe₂O₃ or K₂O. The second conductive layer 12 has a thickness ranging from 20 nm to 50 nm. For example, the thickness may be 20 nm, 30 nm, 45 nm, 50 nm, and the like.

The third conductive layer 13 is made of a material having a high refractivity, such as may be TiO₂, Nb₂O₅, Si₃N₄, Ta₂O₅, and ZrO₂. The third conductive layer 13 has a refractivity ranging from 1.8 to 2.5, and a thickness ranging from 50nm to 80nm. For example, the thickness may be 50nm, 60nm, 75nm or 80nm, and the like.

In an embodiment of the present disclosure, an organic light-emitting device includes a first electrode 10, an organic functional layer 30 and a second electrode 20, which are sequentially laminated on a substrate. The first electrode 10 may function as a negative electrode, and the corresponding second electrode 20 is a positive electrode. Alternatively, the first electrode 10 may function as a positive electrode, and the corresponding second electrode 20 is a negative electrode.

The first electrode 10 may be made of a material having a large work function, so that the holes may be easily injected into the organic functional layer. The material thereof may specifically include: a metal such as silver, zinc, gold, and the like and an alloy thereof; a metal oxide such as zinc oxide, indium oxide, indium tin oxide (ITO), indium zinc oxide (IZO), and the like; a compound of a metal and an oxide or a conductive polymer and the like.

The second electrode 20 may be made of a material having a small work function, so that electrons may be easily injected into the organic functional layer. The material thereof may specifically include: a metal such as magnesium, calcium, sodium, potassium, silver, and an alloy thereof; or a composite material such as LiF/Al or Li₂O/Al, and the like. However, in a case that the second electrode is made of a nontransparent material (such as a metal), the second electrode 20 must be a film layer which is thin and transparent.

The organic functional layer 30 in the present disclosure may be a multilayer structure. For example, the organic functional layer 30 may include a hole injection layer, a hole transport layer, an organic light-emitting layer, an electron transport layer, and the like. A material of the hole injection layer is preferably a material capable of ideally receiving the holes from the first electrode 10 at a low voltage. A material of the hole transport layer is preferably an appropriate material having a high hole mobility, to be able to transport the holes from the hole injection layer to the organic light-emitting layer. The material of the hole transport layer may specifically include, but is not limited to, an aromatic amine-based organic material, a conductive polymer, a block copolymer having both a conjugated portion and a non-conjugated portion, and the like. The material of the organic light-emitting layer is preferably a material capable of emitting visible light by receiving and recombining the holes from the hole transport layer and the electrons from the electron transport layer. A material of the electron transport layer is preferably an appropriate material having a high electron mobility, which may transport the electrons from the second electrode 20 to the organic light-emitting layer.

In addition, the technical features related to the different embodiments of the present disclosure described below may be combined with each other as long as there is no conflict between them.

### First Embodiment

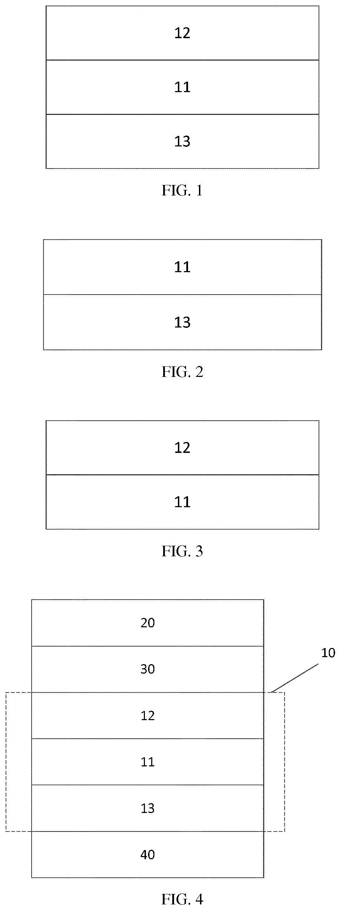

As shown in FIG. 1, in this embodiment, an electrode includes a first conductive layer 11, and further includes a second conductive layer 12 and a third conductive layer 13 respectively laminated at both opposite sides of the first conductive layer 11. The second conductive layer 12 and the third conductive layer 13 are both transparent conductive layers.

In this embodiment, the first conductive layer 11 is made of gold with a thickness ranging from 500 nm to 600 nm, preferably 550nm. A reflectivity corresponding to the thickness is 53%, and a light transmittance corresponding to the thickness is 42%. The reflectivity and the light transmittance of the first conductive layer 11 with the thickness are substantially equal, thereby improving an extraction efficiency of light. The first conductive layer 11 is a transflective conductive layer. The transflective conductive layer is used for adjusting a phase difference generated when the light emitted from the transflective conductive layer is reflected.

The second conductive layer 12 is made of Al₂O₃ with a thickness of 30 nm. Since a Highest Occupied Molecular Orbital (HOMO) energy level of the second conductive layer 12 is -5.6eV, and a HOMO energy level of a hole transport material in a layer of OLED is lower than -4.6eV, there is a difference in HOMO energy level between the second conductive layer 12 and the hole transport material in the organic functional layer 30 of the OLED to which the electrode is applied. The difference in energy level facilitates the migration of the electrons in the organic functional layer 30 of the OLED, thereby facilitating the injection of the holes, and enabling to reduce absorption of OLED photon energy by a metal surface coupling of the electrode.

The third conductive layer 13 is made of TiO₂ with a thickness of 60 nm. A refractivity of the third conductive layer 13 is 2.2, and an extinction coefficient thereof is 3.9^{∗}10⁻⁵cm^{2∗}mol⁻¹. The thickness of the third conductive layer 13 is equal to one quarter of a wavelength of blue light in the third conductive layer. In addition, with the thickness, when the light is again emitted from air toward the electrode, reflected light from both surfaces of the third conductive layer 13 both has half-wave loss, an optical path difference between the reflected light from the rear surface of the third conductive layer 13 and the reflected light from the front surface of the third conductive layer 13 is exactly a half wavelength. At this time, it is not the reflected light and the incident light but the reflected light from the front and rear surfaces of the third conductive layer 13 that has the destructive interference effect, thereby increasing the energy of the transmitted light and improving the extraction efficiency of the light.

In the electrode of the present disclosure, by using the transparent conductive layers respectively laminated at both sides of the first conductive layer 11, the light is reflected multiple times inside the electrode, enabling to generate a microcavity effect and a destructive interference effect, thereby enabling to improve an extraction efficiency of the light.

As shown in FIG. 4, when a second electrode 20 laminated with the electrode is a reflective electrode, the light is reflected between the reflective electrode 20 and the transflective conductive layer 11. A microcavity structure is formed by the reflective electrode and the transflective conductive layer to generate a microcavity effect, resulting in occurrence of the destructive interference and constructive interference of the light, and finally only an intensity of light of a preset wavelength is maintained and an intensity of light of other wavelength is reduced. When the microcavity structure is adjusted, the reflectivity and the light transmittance in the transflective conductive layer may be controlled by adjusting the thickness of the transflective conductive layer, thereby adjusting the phase difference generated when the light is reflected in the transflective conductive layer. As shown in FIG. 4, at the same time, the work function of the first conductive layer 11 is 5.1 eV. The first conductive layer 11 is made of a material having a large work function, enabling to reduce an energy level barrier, and the holes are injected into the organic functional layer 30 easily.

### Second Embodiment

As shown in FIG. 2, in this embodiment, an electrode includes a first conductive layer 11 and a third conductive layer 13 laminated at a side of the first conductive layer 11.

The first conductive layer 11 is made of copper with a thickness of 200nm. A reflectivity corresponding to the thickness is 56%, and a light transmittance corresponding to the thickness is 40%.

The third conductive layer 13 is made of Nb₂O₅ with a refractivity of 2.26, and a thickness of 50nm.

When a second electrode 20 laminated with the electrode is a reflective electrode, a microcavity structure is formed by the first conductive layer 11 and the reflective electrode to generate a microcavity effect, resulting in occurrence of the destructive interference and constructive interference of the light, and finally only an intensity of light of a preset wavelength is maintained and an intensity of light of other wavelength is reduced. The third conductive layer 13 destructs the reflected light from the front and rear surfaces thereof, thereby increasing the energy of the transmitted light, further improving the extraction efficiency of the light.

The specific structural details of the first conductive layer 11 and the third conductive layer 13 which are not described in detail in this embodiment, please refer to the first embodiment, and details are not described herein again.

### Third Embodiment

As shown in FIG. 3, in this embodiment, an electrode includes a first conductive layer 11 and a second conductive layer 12 laminated at a side of the first conductive layer 11.

The first conductive layer 11 is made of indium with a thickness of 600nm. A reflectivity corresponding to the thickness is 48%, and a light transmittance corresponding to the thickness is 50%.

The second conductive layer 12 is made of Fe₂O₃ with a refractivity of 1.99, and a thickness of 45nm.

As shown in FIG. 4, when a second electrode 20 laminated with the electrode is a reflective electrode, a microcavity structure is formed by the first conductive layer 11 and the reflective electrode to generate a microcavity effect, resulting in occurrence of the destructive interference and constructive interference of the light, and finally only an intensity of light of a preset wavelength is maintained and an intensity of light of other wavelength is reduced. The second conductive layer 12 is used for improving the injection of the holes, thereby reducing the absorption of the OLED photon energy by a metal surface coupling of the electrode.

The specific structural details of the first conductive layer 11 and the second conductive layer 12 which are not described in detail in this embodiment, please refer to the first embodiment, and details are not described herein again.

### Fourth Embodiment

As shown in FIG. 4, an organic light-emitting device (OLED) is provided in this embodiment. The OLED in this embodiment is a bottom light-emitting device. A first electrode 10 is a transparent positive electrode made of indium tin oxide. A second electrode 20 is a metal negative electrode, functioning as a reflective electrode and made of LiF/Al.

In this embodiment, as shown in FIG. 4, the first electrode 10 includes a first conductive layer 11 and a second conductive layer 12 and a third conductive layer 13 laminated at both opposite sides of the first conductive layer 11.

The first conductive layer 11 is made of gold with a thickness of 550nm. A reflectivity corresponding to the thickness is 53%, and a light transmittance corresponding to the thickness is 42%.

The second conductive layer 12 is made of Al₂O₃ with a thickness of 30 nm.

The third conductive layer 13 is made of TiO₂ with a thickness of 60 nm.

The OLED in this embodiment is a bottom light-emitting device, and the light is emitted from an organic functional layer 30, passing through the third conductive layer 13, the first conductive layer 11 and the second conductive layer 12 in sequence, and finally emitted from a substrate 40. The second conductive layer 12 can reduce the absorption of the OLED photon energy by the metal surface coupling, so that the second conductive layer 12 is provided at a position close to the second electrode 20, which can ensure that the photon energy does not decrease after the light is emitted from the organic functional layer 30, thereby not affecting an extraction efficiency of the light. Furthermore, the third conductive layer 13 can destruct the reflected light from the front and rear surfaces thereof, increasing the energy of the transmitted light. Thus, by providing the third conductive layer 13 at a position close to the substrate 40, the energy of the transmitted light is further increased before the light is emitted from the first electrode 10, thereby improving the extraction efficiency of the light.

As another alternative implementation of this embodiment, the first electrode 10 includes a first conductive layer 11 and a second conductive layer 12 laminated above the first conductive layer 11.

As another alternative implementation of this embodiment, the first electrode 10 includes a first conductive layer 11 and a third conductive layer 13 laminated below the first conductive layer 11.

The specific structural details of the first electrode 10 which are not described in detail in this embodiment, please refer to the first embodiment, and details are not described herein again.

In the organic light-emitting device of the present disclosure, by the laminated first electrode 10 including the first conductive layer 11 and the transparent conductive layers laminated at both sides of the first conductive layer 11 , light is reflected multiple times inside the electrode, enabling to generate a microcavity effect and a destructive interference effect between the first electrode 10 and the second electrode 20, thereby enabling to improve an extraction efficiency of the light.

It is apparent that the above-described embodiments are merely examples for clear descriptions, but not intended to limit the implementations. Other changes or variations of the various forms may be made by those skilled in the art based on the above description. There is no need and no way to exhaust all of the implementations. Obvious changes or variations resulting therefrom are still within the scope of the invention.

## Claims

1. An organic light-emitting device, comprising a first electrode, an organic functional layer and a second electrode sequentially laminated on a substrate, **characterized in that** the first electrode has a first side and a second side opposite to the first side, and comprises:
a first conductive layer; and
a second conductive layer, laminated at the first side of the first conductive layer, the second conductive layer being a transparent conductive layer.

2. The organic light-emitting device according to claim 1, **characterized in that** the first electrode further comprises a third conductive layer laminated at the second side of the first conductive layer; and
the third conductive layer is a transparent conductive layer.

3. The organic light-emitting device according to claim 1, **characterized in that** the first conductive layer is a transflective conductive layer.

4. The organic light-emitting device according to claim 1, **characterized in that** the second conductive layer has a thickness ranging from 20 nm to 50 nm.

5. The organic light-emitting device according to claim 2, **characterized in that** the third conductive layer has a thickness ranging from 50 nm to 80 nm.

6. The organic light-emitting device according to claim 1, **characterized in that** the second electrode is a reflective electrode.

7. The organic light-emitting device according to claim 1, **characterized in that** a microcavity structure is formed by the second electrode and the first electrode.

8. The organic light-emitting device according to claim 2, **characterized in that** a microcavity structure is formed by the second electrode and the first conductive layer of the first electrode when the second electrode is a reflective electrode.

9. The organic light-emitting device according to claim 8, **characterized by** further comprising a substrate, wherein the substrate and the first conductive layer are provided on opposite sides of the second conductive layer, the second conductive layer is provided at a position close to the second electrode, and the third conductive layer is provided at a position close to the substrate.

10. An electrode applicable to an organic light-emitting device, **characterized by** having a first side and a second side opposite to the first side, and comprising:
a first conductive layer; and
a second conductive layer, laminated at the first side of the first conductive layer, the second conductive layer being a transparent conductive layer.

11. The electrode according to claim 10, **characterized by** further comprising a third conductive layer laminated at the second side of the first conductive layer; and
the third conductive layer is a transparent conductive layer.

12. The electrode according to claim 10, **characterized in that** the first conductive layer is a transflective conductive layer.

13. The electrode according to claim 10, **characterized in that** the second conductive layer has a thickness ranging from 20 nm to 50 nm.

14. The electrode according to claim 11, **characterized in that** the third conductive layer has a thickness ranging from 50 nm to 80 nm.

15. The electrode according to claim 10, **characterized in that** the first conductive layer has a thickness ranging from 500 nm to 600 nm.
